(19) **Europäisches Patentamt**
**European Patent Office**
**Office européen des brevets**

(11) **EP 4 693 900 A1**

(12) **EUROPEAN PATENT APPLICATION**
published in accordance with Art. 153(4) EPC

(43) Date of publication:
**11.02.2026 Bulletin 2026/07**

(21) Application number: **24779585.9**

(22) Date of filing: **15.03.2024**

(51) International Patent Classification (IPC):
**H03H 9/17** (2006.01)          **H10N 30/87** (2023.01)
**H10N 30/853** (2023.01)

(52) Cooperative Patent Classification (CPC):
**H03H 9/17; H10N 30/853; H10N 30/87**

(86) International application number:
**PCT/JP2024/010236**

(87) International publication number:
**WO 2024/203457 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.03.2023 JP 2023055029**

(71) Applicant: **Nitto Denko Corporation
Ibaraki-shi, Osaka 567-8680 (JP)**

(72) Inventors:
• **NAKAMURA, Daisuke
Ibaraki-shi, Osaka 567-8680 (JP)**

• **TSUBURAOKA, Gaku
Ibaraki-shi, Osaka 567-8680 (JP)**
• **AOKI, Yuzuki
Ibaraki-shi, Osaka 567-8680 (JP)**
• **SAKATA, Koichi
Ibaraki-shi, Osaka 567-8680 (JP)**
• **KOBAYASHI, Kento
Ibaraki-shi, Osaka 567-8680 (JP)**
• **NAKAI, Takahiro
Ibaraki-shi, Osaka 567-8680 (JP)**

(74) Representative: **Müller-Boré & Partner
Patentanwälte PartG mbB
Friedenheimer Brücke 21
80639 München (DE)**

(54) **BAW RESONATOR AND ELECTRONIC APPARATUS**

(57)     A BAW resonator that exhibits an effect of confining energy within the BAW resonator, while reducing wire resistance, is provided. The BAW resonator (1) of the present invention includes a support base (10), an acoustic mirror layer (20) in which one pair of a high acoustic impedance layer (21) and a low acoustic impedance layer (22) or two or more pairs in which high acoustic impedance layers (21) and low acoustic impedance layer (22) are alternately stacked, a first electrode (40), a piezoelectric layer (50) having a wurtzite crystal structure, and a second electrode (60) stacked in this order, wherein an intermediate layer (30) formed of an insulator is provided between the acoustic mirror layer (20) and the first electrode (40), the intermediate layer (30) has an acoustic impedance that is higher than an acoustic impedance of each low acoustic impedance layer (21), and the first electrode (40) has an acoustic impedance that is lower than an acoustic impedance of each high acoustic impedance layer (21).

FIG.1

**Description**

TECHNICAL FIELD

The present invention relates to BAW resonators and electronic devices.

BACKGROUND ART

A bulk acoustic wave (BAW) resonator includes a piezoelectric layer formed of a piezoelectric material between two electrode layers. The BAW resonator is used, for example, as an electronic part, such as a BAW filter or the like, in an electronic device utilizing an piezoelectric effect of the piezoelectric layer.

As the BAW resonator, for example, a BAW resonator, in which an acoustic stack is arranged on a reflective element of a substrate, is disclosed. In the acoustic stack, a first electrode, a first diffusion barrier layer, a piezoelectric layer, a second diffusion barrier layer, and a second electrode are stacked (see, for example, Patent Document 1).

In the BAW resonator of Patent Document 1, the first electrode disposed on the substrate of the BAW resonator is formed using a heavy metal having a high acoustic impedance, such as Mo or the like, in order to confine the energy from the reflective element disposed in the substrate within the BAW resonator.

CITATION LIST

PATENT DOCUMENT

Patent Document 1: U.S. Patent No. 11,018,651

Summary of the Invention

Technical Problem

However, when a first electrode is formed using a heavy metal having a high acoustic impedance, such as Mo or the like, resistance of the first electrode becomes high, and therefore it is disadvantageous in the case where the first electrode is used for a transmission line. In addition, as a resonant frequency increases, a thickness of an electrode needs to be reduced. In the case where the first electrode is used in a high frequency range, such as in application of 5G or the like, the first electrode becomes very thin, which may cause ohmic loss, resulting in deterioration of filter characteristics of the BAW resonator.

One aspect of the present invention aims to provide a BAW resonator that can exhibit an effect of confining energy within the BAW resonator, while reducing wire resistance.

SOLUTION TO THE PROBLEM

According to one aspect of the present invention, a BAW resonator includes:

a support base;
an acoustic mirror layer including one pair of a high acoustic impedance layer and a low acoustic impedance layer, or two or more pairs of high acoustic impedance layers and low acoustic impedance layers, in which the high acoustic impedance layers and the low acoustic impedance layers are alternately stacked;
a first electrode;
a piezoelectric layer having a wurtzite crystal structure; and
a second electrode,
the support base, the acoustic mirror layer, the first electrode, the piezoelectric layer, and the second electrode being stacked in the order as mentioned,
wherein an intermediate layer formed of an insulator is provided between the acoustic mirror layer and the first electrode,
the intermediate layer has an acoustic impedance that is higher than an acoustic impedance of each low acoustic impedance layer, and
the first electrode has an acoustic impedance that is lower than an acoustic impedance of each high acoustic impedance layer.

EFFECTS OF THE INVENTION

The BAW resonator according to one aspect of the present invention can exhibit an effect of confining energy within the BAW resonator, while reducing wire resistance.

BRIEF DESCRIPTION OF THE DRAWING

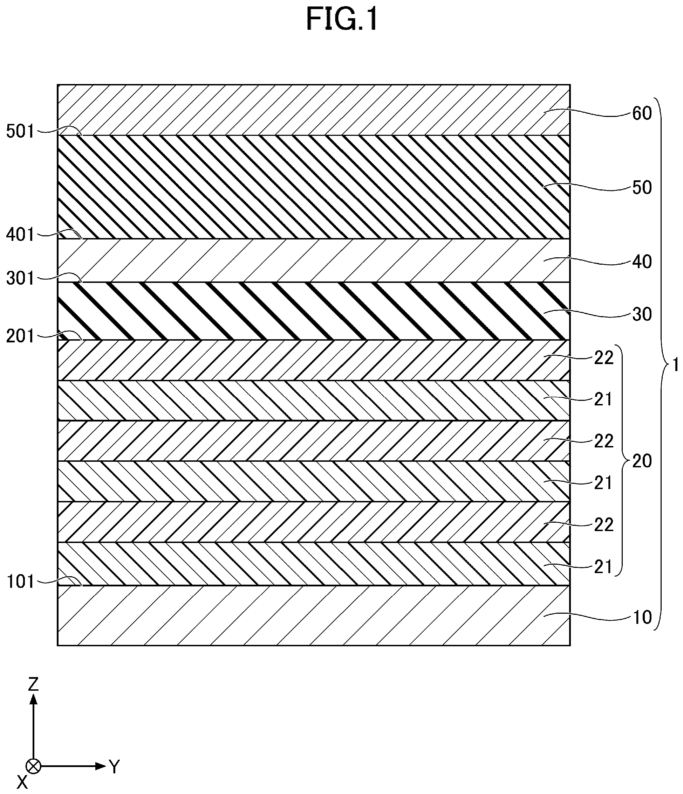

[Fig. 1] Fig. 1 is a schematic cross-sectional view illustrating a configuration of a BAW resonator according to an embodiment of the present invention.

DETAILED DESCRIPTION OF THE EMBODIMENTS

Embodiments of the present invention will be described in detail hereinafter. In order to facilitate understanding of the description, the same reference numerals are given to the same components throughout the drawings, and redundant description will be omitted. In addition, the scale of each member in the drawings may be different from the actual scale. In the present specification, "to" representing a numeral range indicates that the numerical values described before and after the "to" are included in the numeral range as a lower limit and an upper limit, unless otherwise specified.

<Piezoelectric element>

Fig. 1 is a schematic cross-sectional view illustrating a configuration of the piezoelectric element according to the present embodiment. As illustrated in Fig. 1, the BAW resonator 1 includes a support base 10, an acoustic mirror layer 20, an intermediate layer 30, a first electrode 40, a piezoelectric layer 50, and a second electrode 60, stacked in the order as mentioned from the support base 10 side. The BAW resonator 1 may be formed in any shape, such as a sheet shape (film shape) or the like.

In the present specification, the BAW resonator 1 is represented by a three-dimensional orthogonal coordinate system in three axial directions (X-axis direction, Y-axis direction, and Z-axis direction), where the X-axis direction is a width direction of the BAW resonator 1, the Y-axis direction is a lengthwise direction of the BAW resonator 1, and the Z-axis direction is a height (thickness) direction (vertical direction) of the BAW resonator 1. The Z-axis direction toward the second electrode 60 side is determined as a positive (+) Z-axis direction, and the z-axis direction toward the support base 10 side is determined as a negative (-) Z-axis direction. For convenience in description, the +Z-axis direction may be referred to as "top" or "upper", and the -Z-axis direction may be referred to as "bottom" or "lower" in the following description, but the above terms do not represent a universal up-down relationship.

In the BAW resonator 1, an intermediate layer 30, which has a higher acoustic impedance than the acoustic impedance of each low acoustic impedance layer 22 of the acoustic mirror layer 20, is disposed between the acoustic mirror layer 20 and the first electrode 40, and an acoustic impedance of the first electrode 40 is lower than the acoustic impedance of each high acoustic impedance layer 21 of the acoustic mirror layer 20. Thus, the BAW resonator 1 can create the acoustic impedance variation among the acoustic mirror layer 20, the intermediate layer 30, and the first electrode 40. In addition, the first electrode 40 can be formed using a material having a low acoustic impedance so that a resistivity of the first electrode 40 can be reduced. Accordingly, the BAW resonator 1 can exhibit an effect of confining vibration energy transmitted from the acoustic mirror layer 20, while reducing the wire resistance of the first electrode 40.

[Support base]

As illustrated in Fig. 1, the support base 10 is a substrate on which a stack of the acoustic mirror layer 20, the intermediate layer 30, the first electrode 40, the piezoelectric layer 50, and the second electrode 60 is disposed. In order to impart bendability to the BAW resonator 1, the support base 10 may have flexibility.

The material constituting the support base 10 is not limited to a particular type of the material. Any material may be used as long as the material constituting the support base 10 is capable of stably supporting the stack. For example, a plastic base, a metal foil, a metal plate, a silicon (Si) substrate, an inorganic dielectric base, a glass base, or the like may be used.

In the case where a plastic base is used, a material having flexibility, which can impart bendability to the BAW resonator 1 including the piezoelectric layer 50, is preferably used.

As a material for forming the plastic base, for example, polyethylene terephthalate (PET), polyethylene naphthalate (PEN), polycarbonate (PC), an acrylic resin, a cycloolefin-based polymer, a polyamide (PA) resin, a polyimide (PI) resin, polyphenylene sulfide (PPS), polytetrafluoroethylene (PTFE), a diallylphthalate resin (PDAP) or the like can be used.

As a material for forming the metal foil, a metal, such as Au, Pt, Ag, Ti, Al, Mo, Ru, Cu, or the like, may be used.

As a material for forming the metal plate, for example, aluminum, copper, stainless steel, tantalum, or the like may be used.

As a material for forming the inorganic dielectric base, for example, MgO, sapphire, or the like, may be used.

The thickness of the support base 10 is not limited to a particular thickness, and may be appropriately determined according to the intended use of the BAW resonator 1, the material of the support base 10, or the like. For example, the thickness of the support base 10 may be 20 $\mu$m to 725 $\mu$m. When the thickness of the support base 10 is 20 $\mu$m to 725 $\mu$m, the support base 10 can stably support a layer stack including a stack of the acoustic mirror layer 20, the intermediate layer 30, the first electrode 40, the piezoelectric layer 50, and the second electrode 60. In addition, warpage of the support base 10 is minimized, and influence of the warpage of the support base 10 on a piezoelectric performance can be reduced so that the BAW resonator 1 can have a desired bendability.

In the present specification, the thickness of the support base 10 is a length of the support base 10 in the vertical direction with respect to the main surface of the support base 10. The method of measuring the thickness of the support base 10 is not limited to a particular method, and any measurement method can be used. The thickness of the support base 10 may be, for example, a thickness measured at an arbitrary location on a cross-section of the support base 10, or an average value of measured values obtained by measuring the thickness at several points in an arbitrary location on the cross-section of the support base 10. The definition of the thickness is similarly applied to other members hereinafter.

[Acoustic mirror layer]

As illustrated in Fig. 1, the acoustic mirror layer 20 is disposed on an upper main surface (upper surface) 101 of the support base 10. The acoustic mirror layer 20 may be composed of a multilayer acoustic film having varied intrinsic acoustic impedances. The acoustic mirror layer 20 is a multilayer film in which two or more pairs of high acoustic impedance layers 21 having a certain intrinsic acoustic impedance and low acoustic impedance layers 22 having a lower intrinsic acoustic impedance than the intrinsic acoustic impedance of the high acoustic impedance layers 21 are alternately stacked.

When the resonant vibration is transmitted to the acoustic mirror layer 20, the vibration energy of the resonance is reflected by the acoustic mirror layer 20. The speed at which the vibration wave (elastic wave) propagates through the high acoustic impedance layer 21 is different from the speed at which the vibration wave propagates through the low acoustic impedance layer 22. By designing a thickness of the acoustic mirror layer 20 so that the reflected waves are enhanced by interference at each interface between the layers constituting the acoustic mirror layer 20, the thermal energy is released in the direction toward the support base 10 while returning the vibration energy of the resonance toward the incident direction of the elastic wave without being affected by the support base 10.

The high acoustic impedance layer 21 is formed of a material having a high density or bulk modulus, such as W, Mo, $Ta_2O_5$, ZnO, or the like. The low acoustic impedance layer 22 is formed of a material having a lower density or bulk modulus than the density or bulk modulus of the high acoustic impedance layer 21.

The low acoustic impedance layer 22 may be formed of a material having a low density or bulk modulus, such as $SiO_2$ or the like. The low acoustic impedance layer 22 may be an amorphous layer, or a dominantly amorphous layer. Since the low acoustic impedance layer 22 is a dominantly amorphous layer, the stress in the high acoustic impedance layer 21 can be reduced.

The high acoustic impedance layer 21 and the low acoustic impedance layer 22 are formed on the support base 10 by sputtering or the like.

[Intermediate layer]

As illustrated in Fig. 1, the intermediate layer 30 is disposed on the upper surface 201, which is the surface of the acoustic mirror layer 20 on the first electrode 40 side, and is disposed between the acoustic mirror layer 20 and the first electrode 40.

The intermediate layer 30 has a function of reflecting the vibration energy excited by the piezoelectric resonator, which is composed of the first electrode 40, the piezoelectric layer 50, and the second electrode 60, and the intermediate layer 30 is a layer formed of an insulator. If the intermediate layer 30 is a layer having conductivity, such as a conductor or the like, the intermediate layer 30 is regarded as constituting part of an electrode, and a thickness of the electrode becomes a sum of the thickness of the intermediate layer 30 and the thickness of the first electrode 40. The mass of the electrode is regarded as a mass greater than that originally possessed by the first electrode 40. This results in a state where excitation of vibration is suppressed, leading to a shift to the lower-frequency side. The intermediate layer 30 may be a layer including components other than an insulator, such as metal or the like, as long as the intermediate layer 30 has an insulating property.

The intermediate layer 30 has a higher acoustic impedance than the acoustic impedance of each low acoustic impedance layer 22 of the acoustic mirror layer 20, and preferably has an acoustic impedance that is at a level between the acoustic impedance of each high acoustic impedance layer 21 and the acoustic impedance of the first electrode 40. The intermediate layer 30 has an acoustic impedance that is at a level between the acoustic impedance of each high acoustic impedance layer 21 and the acoustic impedance of the first electrode 40, and therefore the acoustic impedance variation can be provided among the acoustic mirror layer 20, the intermediate layer 30, and the first electrode 40 in the order of low, high, and low. Thus, the vibration energy is efficiently reflected, and an effect of confining the energy between the electrodes can be exhibited more efficiently.

The acoustic impedance of the intermediate layer 30 is preferably $3.0 \times 10^7$ kg/(m$^2$·s) to $6.0 \times 10^7$ kg/(m$^2$·s), more preferably $3.3 \times 10^7$ kg/(m$^2$·s) to $5.5 \times 10^7$ kg/(m$^2$·s), and yet more preferably $3.5 \times 10^7$ kg/ (m$^2$·s) to $5.0 \times 10^7$ kg/(m$^2$·s). The acoustic impedances of metals and the like generally used for an electrode, a piezoelectric layer, or the like constituting a BAW resonator are presented in Table 1.

[Table 1]

| Type | Acoustic impedance [kg/(m$^2$·s)] |
|---|---|
| Mo | $6.3 \times 10^7$ |
| Pt | $7.0 \times 10^7$ |
| Ru | $6.7 \times 10^7$ |
| W | $1.0 \times 10^8$ |
| Ir | $1.1 \times 10^8$ |
| Al | $1.7 \times 10^7$ |
| SiO$_2$ | $1.3 \times 10^7$ |
| AlN | $3.6 \times 10^7$ |
| ZnO | $3.6 \times 10^7$ |
| Ta$_2$O$_5$ | $3.4 \times 10^7$ |

With reference to Table 1, if the acoustic impedance of the intermediate layer 30 is in the above preferable range, the intermediate layer 30 can be formed using ZnO or AlN, and therefore the intermediate layer 30 can be easily formed.

A material for forming the intermediate layer 30 may be any material as long as the material is an insulator having a higher acoustic impedance than the acoustic impedance of the low acoustic impedance layer 22, and may be the same material as the material of the piezoelectric layer 50. As the material for forming the intermediate layer 30, for example, ZnO, AlN, Al$_2$O$_3$, SiON, SiOC, or the like may be used. The above materials may be used alone or in combination. Among the above materials, ZnO and AlN are preferable with ZnO being more preferred. The intermediate layer 30 preferably includes ZnO as a main component, and may include other components as auxiliary components in any amount as appropriate.

The intermediate layer 30 can be formed by sputtering, chemical vapor deposition (CVD), a sol-gel method or the like.

The thickness of the intermediate layer 30 is preferably 15 nm to 35 nm. The lower limit of the thickness of the intermediate layer 30 is more preferably 20 nm or greater and yet more preferably 25 nm or greater. When the thickness of the intermediate layer 30 is 15 nm to 35 nm, the intermediate layer 30 can function as a higher acoustic impedance layer with respect to the low acoustic impedance layer 22 so that an efficiency of reflecting vibration energy can be enhanced.

[First electrode]

As illustrated in Fig. 1, the first electrode 40 is disposed on the upper main surface (upper surface) 301 of the intermediate layer 30. The first electrode 40 is formed into a thin film over a part of or a whole surface of the intermediate layer 30.

The first electrode 40 has a lower acoustic impedance than the acoustic impedance of each high acoustic impedance layer 21 of the acoustic mirror layer 20.

The first electrode 40 has a lower acoustic impedance than the acoustic impedance of each high acoustic impedance layer 21. A material having conductivity can be used for the first electrode 40. As the material, a metal, such as Pt, Au, Ag, Cu, Mg, Al, Si, Ti, Cr, Fe, Ni, Zn, Y, Sc, Rb, Zr, Hf, Nb, Rh, Pd, Sn, Ta, or the like, can be used.

From the standpoint of the acoustic impedance of the first electrode 40 to be lower than the acoustic impedance of the intermediate layer 30, the acoustic impedance of the first electrode 40 is preferably lower than $3.0 \times 10^7$ kg/(m$^2$·s), more preferably $2.5 \times 10^7$ kg/(m$^2$·s) or lower, and yet more preferably $2.0 \times 10^7$ kg/(m$^2$·s) or lower. When the acoustic impedance of the first electrode 40 is lower than $3.0 \times 10^7$ kg/(m$^2 \cdot$s), it is easy to select a material of the intermediate layer 30, which has a higher acoustic impedance than the acoustic impedance of the first electrode 40.

The resistivity of the first electrode 40 is preferably $3.0 \times 10^{-7}$ $\Omega$m or lower, more preferably $2.8 \times 10^{-7}$ $\Omega$m or lower, and yet more preferably $2.5 \times 10^{-7}$ $\Omega$m or lower. The resistivities of metals generally used for an electrode constituting a BAW resonator are presented in Table 2.

[Table 2]

| Type | Resistivity [$\Omega$m] |
|---|---|
| Mo | $5.0 \times 10^{-8}$ |
| Pt | $1.1 \times 10^{-7}$ |
| Ru | $7.1 \times 10^{-8}$ |
| W | $5.3 \times 10^{-8}$ |
| Ir | $5.2 \times 10^{-8}$ |
| Al | $2.7 \times 10^{-8}$ |

With reference to Table 2, when the resistivity of the first electrode 40 is $3.0 \times 10^{-7}$ $\Omega$m or lower, it is easy to select a material for forming the intermediate layer 30, which has a high acoustic impedance than the acoustic impedance of the first electrode 40.

A ratio (film thickness ratio) of the thickness of the first electrode 40 to the thickness of the intermediate layer 30 is preferably 3 to 11, more preferably 4 to 10, and yet more preferably 5 to 9. When the film thickness ratio is within the above preferable range, the function of the intermediate layer 30 is sufficiently exhibited, and reflection of acoustic waves can be sufficiently performed. In addition, an increase in wire resistance can be inhibited, thereby inhibiting attenuation.

The surface resistivity of the first electrode 40 is preferably lower than 0.24 $\Omega$/sq, more preferably 0.22 $\Omega$/sq or lower, and yet more preferably 0.20 $\Omega$/sq or lower. When the surface resistivity is lower than 0.24 $\Omega$/sq, an increase in wire resistance of the first electrode 40 can be inhibited, thereby inhibiting attenuation. The lower limit of the surface resistivity of the first electrode 40 is not particularly limited, and may be set as appropriate.

As represented by the following equation (1), the surface resistivity can be determined by dividing the resistivity of the first electrode 40 by the thickness of the first electrode 40.

Surface resistivity = resistivity of first electrode 40/thickness of first electrode 40       (1)

From the standpoint of minimization of unevenness at an interface between the first electrode 40 and the piezoelectric layer 50, or inhibition of crystal grain boundaries, the first electrode 40 may be an amorphous film. Since the first electrode 40 is an amorphous film, unevenness in a surface of the first electrode 40, or generation of crystal grain boundaries, which causes leakage paths, can be inhibited.

The thickness of the first electrode 40 can be appropriately set. For example, the thickness of the first electrode 40 may be 40 nm to 300 nm. When the thickness of the first electrode 40 is 40 nm to 300 nm, the first electrode 40 functions as an electrode, and the resultant BAW resonator 1 can be made as a thin film.

[Piezoelectric layer]

As illustrated in Fig. 1, the piezoelectric layer 50 is disposed on the upper main surface (upper surface) 401 of the first electrode 40. The piezoelectric layer 50 preferably includes an inorganic material as a main component. The main component means that the amount of the inorganic material is 95 atm% or greater, preferably 98 atm% or greater, and more preferably 99 atm% or greater.

As the inorganic material, a piezoelectric material having a perovskite crystal structure (perovskite crystal material), a piezoelectric material having a wurtzite crystal structure (wurtzite crystal material), or the like can be used.

The wurtzite crystal structure is represented by a general formula: AB (A is a positive element, and B is a negative element). The wurtzite crystal material has a hexagonal unit cell and has a polarization vector in a direction parallel to the c axis.

As the wurtzite crystal material, a material that exhibits a piezoelectricity of a certain value or higher and can be crystallized by a low temperature process at 200°C or lower is preferable. The wurtzite crystal material includes, as the positive element A in the general formula AB, Zn, Al, Ga, Cd, Si, or the like. As the wurtzite crystal material, for example, zinc oxide (ZnO), zinc sulfide (ZnS), zinc selenide (ZnSe), zinc telluride (ZnTe), aluminum nitride (AlN), gallium nitride (GaN), cadmium selenide (CdSe), cadmium telluride (CdTe), silicon carbide (SiC), or the like can be used. Among the above materials, the wurtzite crystal material is preferably ZnO because ZnO relatively easily achieves a c-axis orientation in a desired manner even by a low temperature process. The above wurtzite crystal materials may be used alone or in combination. In the case where two or more wurtzite crystal materials are used in combination, one or more wurtzite crystal materials may be included as main components among all of the wurtzite crystal materials included, and the rest may be included as optional components. Alternatively, layers of wurtzite crystal materials may be stacked to form the piezoelectric layer, or the piezoelectric layer may be formed as one layer using a plurality of targets.

The wurtzite crystal material preferably includes ZnO, is more preferably substantially formed of ZnO, and is yet more preferably formed of only ZnO. The term "substantially" means that inevitable impurities that are inevitably included in a production process may be included other than ZnO.

The inorganic material, such as the wurtzite crystal material or the like, may include, other than above ZnO, AlN, ZnS, ZnSe, and ZnTe, an alkaline earth metal, such as Mg, Ca, Sr, or the like, or a metal, such as V, Ti, Zr, Si, Sr, Li, or the like, within a predetermined range. The above components may be included as elements or in an oxide state. Among the above inorganic materials, the inorganic material is preferably Mg-doped ZnO (MgZnO), in which ZnO is doped with Mg, because an excellent piezoelectric performance is achieved by obtaining both a desired K value that is an index for a piezoelectric performance of the piezoelectric layer 50 and a desired Q value that is an index of sharpness of the piezoelectric performance.

The K value is a value of an electromechanical coupling coefficient k. The square ($k^2$ value) of the electromechanical coupling coefficient of the piezoelectric material included in the piezoelectric layer 50 indicates an energy conversion efficiency of electrical energy, which is determined relative to the piezoelectric material. The higher the energy conversion efficiency of electrical energy, the better the operation efficiency of the BAW resonator 1 including the piezoelectric layer 50. Thus, the BAW resonator 1 has an excellent piezoelectric performance. With the same material and the same composition, as the disturbance of the crystal orientation of the piezoelectric material included in the piezoelectric layer 50 decreases, the $k^2$ value of the piezoelectric material gradually becomes constant while increasing. Specifically, as the disturbance of the crystal orientation of the piezoelectric material decreases, the energy conversion efficiency of the piezoelectric material gradually becomes constant while increasing, and therefore the piezoelectric performance becomes a constant level. Therefore, the larger the electromechanical coupling coefficient k, the larger the $k^2$ value is and the higher the energy conversion efficiency of the piezoelectric material. Thus, the larger electromechanical coupling coefficient k means a high piezoelectric performance. Moreover, as the electromechanical coupling coefficient k increases, the disturbance of the crystal orientation decreases. Thus the larger electrochemical coupling coefficient k means high crystal orientation.

The Q value is a value representing sharpness (a degree of sharpness) of frequency characteristics. The larger Q value means the sharper frequency characteristics.

An amount of one or more additive elements in the piezoelectric layer 50 is not limited to a particular amount, as long as the amount is within a range in which the piezoelectric layer 50 can have a wurtzite crystal structure. A method of measuring the amount of one or more additive elements included in the piezoelectric layer 50 is not limited to a particular method, as long as the measurement method is a method that can perform measurement. The amount of the one or more additive elements included in the piezoelectric layer 50 may be measured, for example, by Rutherford backscattering spectrometry (RBS) using Pelletron 3SDH (manufactured by NEC) as a measuring device, or secondary ion mass spectrometry using dynamic SIMS (D-SIMS) or the like.

The thickness of the piezoelectric layer 50 is not limited to a particular thickness, and may be a thickness with which the piezoelectric layer 50 has a sufficient piezoelectric performance, i.e., polarization characteristics proportional to the pressure, and formation of cracks or the like of the piezoelectric layer 50 can be avoided to thereby stably exhibit a piezoelectric performance. The thickness of the piezoelectric layer 50 may be, for example, 50 nm to 5 $\mu$m. When the thickness of the piezoelectric layer 50 is 50 nm to 5 $\mu$m, formation of cracks can be inhibited, and a sufficient piezoelectric performance can be exhibited.

The crystal orientation of the piezoelectric layer 50 is preferably 5° or less. When the crystal orientation is 5° or less, a desired crystal orientation of the piezoelectric material included in the piezoelectric layer 50 to the c-axis direction (c-axis orientation) is achieved, and the energy conversion efficiency can be increased so that a piezoelectric performance in the thickness direction of the piezoelectric layer 50 can be enhanced. In the case where the piezoelectric layer 50 includes ZnO as the piezoelectric material, ZnO has a wurtzite crystal structure, which has a higher correlation between the crystal orientation and the piezoelectric performance compared to piezoelectric materials having other crystal structures. When the crystal orientation of ZnO is 5° or less, the energy conversion efficiency can be easily increased so that the piezoelectric performance of the BAW resonator 1 can be improved.

The crystal orientation of the piezoelectric layer 50 can be evaluated by a full width at half maximum (FWHM) obtained when the surface of the piezoelectric layer 50 is measured by the X-ray rocking curve (XRC) method. Specifically, the crystal orientation of the piezoelectric layer 50 is represented by FWHM of the peak waveform of the rocking curve obtained when the diffraction on the

(0002) plane of the crystal of the piezoelectric material included as a main component in the piezoelectric layer 50 is measured by the XRC method. In the case where the piezoelectric material included in the piezoelectric layer 50 has a wurtzite crystal structure, such as ZnO or the like, FWHM indicates the degree of parallelism of the arrangement of the crystals constituting the piezoelectric material in the c-axis direction. Thus, FWHM of the peak waveform of the rocking curve obtained by the XRC method can be used as an index of the c-axis orientation of the piezoelectric layer 50. Accordingly, it can be evaluated that the smaller FWHM of the rocking curve, the higher the crystal orientation of the piezoelectric layer 50 in the c-axis direction.

In addition to FWHM of the rocking curve obtained by measuring diffraction on a certain crystal plane (e.g., the (0002) plane of the ZnO crystal) of the piezoelectric material included in the piezoelectric layer 50 by the XRC method, the crystal orientation of the piezoelectric layer 50 may be evaluated by a peak intensity. Specifically, the crystal orientation of the piezoelectric layer 50 may be evaluated using, as an evaluation value, a value obtained by dividing the integral value of the peak intensity by FWHM. For example, it can be evaluated that the larger the evaluation value, which is obtained by dividing the integral value of the peak intensity by FWHM, the higher the crystal orientation of the piezoelectric layer 50.

In the case where two or more inorganic materials are used in combination in the piezoelectric layer 50, the piezoelectric layer may be formed by stacking piezoelectric layers formed of the respective inorganic materials.

[Second electrode]

As illustrated in Fig. 1, the second electrode 60 is disposed on the upper main surface (upper surface) 501 of the piezoelectric layer 50, and is arranged to face the first electrode 40. The second electrode 60 can be formed of any material having conductivity. As the material, the same material as the material of the first electrode 40 can be used.

Similarly to the first electrode 40, the second electrode 60 may be formed into a thin film over a part of or a whole surface of the piezoelectric layer 50, and may be formed in any shape as appropriate.

The thickness of the second electrode 60 can be appropriately set. For example, the thickness of the second electrode 60 is preferably 40 nm to 300 nm. When the thickness of the second electrode 60 is within the above preferable range, the second electrode 60 functions as an electrode, and a resultant BAW resonator 1 can be formed as a thin film.

The method of producing the BAW resonator 1 is not limited to a particular method, and any appropriate production method can be used. One example of the method of producing the BAW resonator 1 will be described.

First, on an upper surface of a support base 10 formed into a predetermined size, high acoustic impedance layers 21 and low acoustic impedance layer 22 are alternately stacked, as one high acoustic impedance layer 21 and one low acoustic impedance layer 22 being a pair, to thereby form an acoustic mirror layer 20.

The method of forming the high acoustic impedance layers 21 and the low acoustic impedance layers 22 is not limited to a particular method, and may be either a dry process or a wet process. When the dry process is used as the method of forming the high acoustic impedance layers 21 and the low acoustic impedance layers 22, thin high acoustic impedance layers 21 and thin low acoustic impedance layers 22 can be easily formed.

Examples of the dry process include sputtering, vapor deposition, and the like. Examples of the wet process include plating and the like.

As the sputtering, for example, direct current (DC) or radio frequency (RF) magnetron sputtering or the like can be used.

Since sputtering is used as the method of forming the high acoustic impedance layers 21 and the low acoustic impedance layers 22, the high acoustic impedance layers 21 and the low acoustic impedance layers 22, both of which have high densities and are thin, are easily formed. Therefore, the method of forming the high acoustic impedance layers 21 and the low acoustic impedance layers 22 is preferably sputtering.

As each high acoustic impedance layer 21, for example, a thin film formed of a material having a high density or volume bulk modulus, such as W, Mo, $Ta_2O_5$, ZnO, or the like, which is formed by DC or RF magnetron sputtering, can be used.

As each low acoustic impedance layer 22, for example, an oxide, such as a $SiO_2$ film or the like, formed by DC or RF magnetron sputtering can be used.

When DC or RF magnetron sputtering is used, metal sputtering may be used, or metal oxide sputtering may be used as sputtering in the case where each high acoustic impedance layer 21 or each low acoustic impedance layer 22 is a metal oxide, such as $Ta_2O_5$, ZnO, $SiO_2$, or the like. In the case where each high acoustic impedance layer 21 is a ZnO film formed by DC or RF magnetron sputtering, a Zn sputtering target or a ZnO sputtering target may be used for sputtering depending on a gas atmosphere used.

Next, an intermediate layer 30 is formed on the upper surface 201 of the acoustic mirror layer 20. The method of forming the intermediate layer 30 is not limited to a particular method. Similarly to the method of forming the high acoustic impedance layers 21 and the low acoustic impedance layers 22, either a dry process or a wet process may be used. The details of the dry process and the wet process are the same as in the method of forming the high acoustic impedance layers 21 and the low acoustic impedance layers 22, thus the detailed description will be omitted.

In the case where a metal oxide film, such as ZnO or the like, is formed as the intermediate layer 30 by DC or RF magnetron sputtering, metal sputtering may be used, or metal oxide sputtering may be used as the sputtering. In the case where the intermediate layer 30 is a ZnO film formed by DC or RF magnetron sputtering, for example, a Zn sputtering target or a ZnO sputtering target may be used for the sputtering depending on a gas atmosphere used.

Next, a first electrode 40 is deposited (formed) on the upper surface 301 of the intermediate layer 30. The method of forming the first electrode 40 is not limited to a particular method. Similarly to the method of forming the high acoustic impedance layers 21 and the low acoustic impedance layers 22, either a dry process or a wet process may be used. The details of the dry process and the wet process are the same as in the method of forming the high acoustic impedance layers 21 and the low acoustic impedance layers 22, thus the detailed description will be omitted.

The first electrode 40 may be formed over an entire upper surface 201 of the acoustic mirror layer 20. Moreover, the first electrode 40 may be formed by patterning the first electrode 40 into a predetermined shape through etching or the like, with the shape selected as appropriate.

Next, a piezoelectric layer 50 is formed on the upper surface of the first electrode 40. For example, the piezoelectric layer 50 may be formed by DC or RF magnetron sputtering in a mixed gas atmosphere including an inert gas, such as Ar or the like, and a trace amount of oxygen using a target including elements constituting a piezoelectric material. By depositing the piezoelectric material on the first electrode 40 by sputtering, the piezoelectric layer 50 is formed.

A stack including the support base 10, the acoustic mirror layer 20, the intermediate layer 30, and the first electrode 40 may be arranged on a film formation plate serving as an anode in a film formation chamber of a sputtering device. The film formation plate may be, for example, rotatable. When the stack including the support base 10, the acoustic mirror layer 20, the intermediate layer 30, and the first electrode 40 is arranged on the film formation plate, the piezoelectric layer 50 can be formed on the first electrode 40 through batch processing.

Moreover, the stack including the support base 10, the acoustic mirror layer 20, the intermediate layer 30, and the first electrode 40 may be wound as an anode around a drum roll that is a film formation roll, instead of the film formation plate. Since the drum roll is arranged in the film formation chamber, the piezoelectric layer 50 can be continuously formed on the first electrode 40 while transporting the stack including the support base 10, the acoustic mirror layer 20, the intermediate layer 30, and the first electrode 40 in a roll to roll system.

The target including elements constituting the piezoelectric material is used as a cathode.

In the case where the piezoelectric material includes a wurtzite crystal material, for example, a target including a wurtzite crystal material may be used as the target. As the target including the wurtzite crystal material, a single or multiple targets including a wurtzite crystal material, which is to be included in the piezoelectric layer 50 as a main component, may be used. The single or multiple targets may be arranged to face the film formation plate with a space between the single or multiple targets and the film formation plate. In the case where multiple targets are used as cathodes, multi-target sputtering is used to form the piezoelectric layer 50 including the wurtzite crystal material. In the case where a single target is used as a cathode, single-target sputtering is used to form the piezoelectric layer 50 including the wurtzite crystal material.

In the case where multiple targets are used as cathodes, targets include mutually different materials that collectively constitute a wurtzite crystal material to be included in the piezoelectric layer 50 as a main component. In the case where multiple targets are used, for example, a target including Zn, a target including Si or Sn, and a target including Al or Mg may be used. As each of the targets, a metal oxide target including oxygen may be used. The multiple targets may be arranged in the film formation chamber by leaving a space between each of the targets. During sputtering, the electric power applied to each of the targets is controlled to adjust the atomic ratio of the composition of the materials constituting the piezoelectric layer 50 according to a type or the like of the wurtzite crystal material to be included in the piezoelectric layer 50.

In the case where a single target is used as a cathode, a single target includes a wurtzite crystal material to be included in the piezoelectric layer 50. In the case where a single target is used, an alloy target in which an atomic ratio of constituent components of the wurtzite crystal material to be included in the piezoelectric layer 50 is adjusted may be used. For example, an alloy target including Zn, and Si or Sn, and Al or Mg can be used. As the alloy target, a metal oxide target including the wurtzite crystal material and oxygen may be used.

In the case where the piezoelectric material is a wurtzite crystal material formed of ZnO, for example, a target of sintered ZnO may be used as the target. The target of sintered ZnO is arranged inside a sputtering device, and a mixed gas including an inert gas, such as Ar or the like, and oxygen is supplied to the sputtering device. Sputtering is performed in the mixed gas atmosphere including the inert gas and oxygen using the target of sintered ZnO so that a piezoelectric layer 50 can be obtained on the first electrode 40 while minimizing the amount of the inert gas incorporated during film formation of ZnO.

In the case where the piezoelectric material is a wurtzite crystal material formed of MgZnO including ZnO and MgO at a predetermined mass ratio, for example, multi-target sputtering using a target of sintered ZnO and a target of sintered MgO may be used. As another example, moreover, single-target sputtering using an alloy target including ZnO and MgO, such as a target of sintered ZnO doped with MgO at a predetermined ratio in advance or the like, may be used.

In the case where the multi-target sputtering is used, a multi-target sputtering device is used as the sputtering device, and a mixed gas including an inert gas, such as Ar or the like, and oxygen is supplied to the multi-target sputtering device. By performing sputtering on the first electrode 40 in the mixed gas atmosphere including the inert gas and oxygen using the target of sintered ZnO and the target of sintered MgO simultaneously and independently, a piezoelectric layer 50 formed as a thin film of MgZnO can be formed on the first electrode 40.

In the case where the single-target sputtering is used, sputtering is performed in a mixed gas atmosphere including an inert gas, such as Ar or the like, and oxygen, by a sputtering device using, for example, a target of sintered ZnO, which is doped with MgO at a predetermined ratio in advance, so that a piezoelectric layer 50 formed as a thin film of MgZnO is formed on the first electrode 40.

The gas atmosphere during sputtering may be an inert gas atmosphere, or a mixed gas atmosphere including an inert gas and oxygen.

The pressure in the gas atmosphere during sputtering may be appropriately determined according to a type of the piezoelectric material, sputtering, or the like. For example, the pressure may be 0.1 Pa to 2.0 Pa.

The film formation temperature for the piezoelectric layer 50 is not limited to a particular film formation temperature, and may be appropriately selected according to a layer configuration of the BAW resonator 1 or the like. For example, the piezoelectric layer 50 may be formed at 150°C or lower.

By using sputtering for formation of the first electrode 40 and the piezoelectric layer 50, uniform films having a strong adhesive force can be formed while a composition ratio of a compound of the target is substantially maintained. In addition, the first electrode 40 and the piezoelectric layer 50 both having desired thicknesses are accurately formed by controlling only the time.

The piezoelectric layer 50 may be formed by stacking several layers.

Next, a second electrode 60 having a predetermined shape is formed on the upper surface 501 of the piezoelectric layer 50. The second electrode 60 can be formed by the same formation method as the formation method of the first electrode 40.

The thickness of the second electrode 60 can be appropriately set. For example, the thickness of the second electrode 60 may be 40 nm to 300 nm.

The second electrode 60 may be formed over a whole upper surface of the piezoelectric layer 50, or may be formed in any shape as appropriate.

By forming the second electrode 60 on the upper surface of the piezoelectric layer 50, a BAW resonator 1 is produced.

After the formation of the second electrode 60, the entire BAW resonator 1 may be subjected to a heat treatment. The heat treatment allows the first electrode 40 and the second electrode 60 to be crystallized so that resistance can be reduced. The heat treatment is not essential. In the case where the support base 10 is formed of a material that is not heat resistant or the like, the heat treatment may not be performed after the formation of the BAW resonator 1.

As described above, the BAW resonator 1 according to the present embodiment includes the support base 10, the acoustic mirror layer 20, the intermediate layer 30, the first electrode 40, the piezoelectric layer 50, and the second electrode 60. The intermediate layer 30 is a layer formed of an insulator, and has a higher acoustic impedance than the acoustic impedance of each low acoustic impedance layer 22 of the acoustic mirror layer 20. The first electrode 40 disposed on the upper surface 301 of the intermediate layer 30 has a lower acoustic impedance than the acoustic impedance of each high acoustic impedance layer 21 of the acoustic mirror layer 20.

The layer that is located at the uppermost position of the acoustic mirror layer 20 and is in contact with the intermediate layer 30 is a low acoustic impedance layer 22. Since the intermediate layer 30 having a higher acoustic impedance than the acoustic impedance of the low acoustic impedance layer 22 is disposed between the low acoustic impedance layer 22 and the first electrode 40 having a lower acoustic impedance than the acoustic impedance of each high acoustic impedance layer 21, the acoustic impedance variation is provided among the low acoustic impedance layer 22, the intermediate layer 30, and the first electrode 40. Since the BAW resonator 1 can provide an acoustic impedance variation among the low acoustic impedance layer 22, the intermediate layer 30, and the first electrode 40, an effect of confining the vibration energy generated in the acoustic mirror layer 20 can be exhibited.

Moreover, the first electrode 40 is formed of a material having a lower acoustic impedance than the acoustic impedance of each high acoustic impedance layer 21. The material having a low acoustic impedance generally has a low resistivity and high conductivity. Therefore, the first electrode 40 can be formed using the material having a low resistivity.

Accordingly, in the BAW resonator 1, the intermediate layer 30 formed of an insulator is disposed between the acoustic mirror layer 20 and the first electrode 40, and an acoustic impedance variation is provided among the low acoustic impedance layer 22, the intermediate layer 30, and the first electrode 40. Therefore, the BAW resonator 1 can exhibit an effect of confining the energy within the BAW resonator 1, while reducing wire resistance.

In addition, since the first electrode 40 can be formed using the material having a low resistivity, the first electrode 40 of the BAW resonator 1 can be used as a transmission line.

In the BAW resonator 1, the intermediate layer 30 has an acoustic impedance that is at a level between the acoustic impedance of each high acoustic impedance layer 21 and the acoustic impedance of the first electrode 40. Thus, in the BAW resonator 1, the level of the acoustic impedance can be adjusted in order of wow, high, and low across the acoustic impedance layer 22, the intermediate layer 30, and the first electrode 40, respectively, so that the acoustic impedance variation can be assuredly provided. Accordingly, the BAW resonator 1 can improve an effect of confining the energy within the BAW resonator 1.

In the BAW resonator 1, the acoustic impedance of the intermediate layer 30 can be set to $3.0 \times 10^7$ kg/(m$^2$·s) to $6.0 \times 10^7$ kg/(m$^2$·s).

Therefore, in the BAW resonator 1, the intermediate layer 30 can be formed using ZnO, AIN, or the like, and an acoustic impedance of each high acoustic impedance layer 21 can be reduced compared to a typical acoustic impedance of a generally used high acoustic impedance layer 21. Accordingly, in the BAW resonator 1, the level of the acoustic impedance can be easily adjusted in the order of low, high, and low from the low acoustic impedance layer 22, the intermediate layer 30, and the first electrode 40 so that an acoustic impedance variation can be easily provided. Thus, the BAW resonator 1 can easily improve the effect of confining the energy within the BAW resonator 1.

In the BAW resonator 1, the acoustic impedance of the first electrode 40 can be set to lower than $3.0 \times 10^7$ kg/(m$^2$·s), and the resistivity of the first electrode 40 can be set to $3.0 \times 10^{-7}$ Ωm or lower. Thus, the intermediate layer 30 can be formed using a typical metal or the like having an acoustic impedance of $3.0 \times 10^7$ kg/(m$^2$·s) or greater. Accordingly, the BAW resonator 1 is easily configured to provide an acoustic impedance variation in which the level of the acoustic impedance is adjusted in the order of low, high, and low from the low acoustic impedance layer 22, the intermediate layer 30, and the first electrode 40. Thus, the BAW resonator 1 can easily improve the effect of confining the energy within the BAW resonator 1.

In the BAW resonator 1, the ratio of the thickness of the first electrode 40 to a thickness of the intermediate layer 30 can be set to 3 to 11. Thus, the influence of the intermediate layer 30 is reduced so that the BAW resonator 1 can reflect vibration energy excited by a piezoelectric resonator that is composed of the first electrode 40, the piezoelectric layer 50, and the second electrode 60, and an increase in the wire resistance of the first electrode 40 can be inhibited.

In the BAW resonator 1, the surface resistivity of the first electrode 40 can be set to lower than 0.24 Ω/sq. Thus, the BAW resonator 1 can inhibit an increase in wire resistance of the first electrode 40 to thereby minimize attenuation.

In the BAW resonator 1, the intermediate layer 30 can be formed of the same material as the material of the piezoelectric layer 50.

In the BAW resonator 1, the intermediate layer 30 can include ZnO as a main component. In the BAW resonator 1, the intermediate layer 30 can be formed of ZnO only or MgZnO. In the case where the first electrode 40 disposed as an upper layer of the intermediate layer 30 is formed of Al or the like, for example, the BAW resonator 1 can be configured in a manner such that the first electrode 40 is formed to have a structure that is advantageous for the ZnO orientation.

In the BAW resonator 1, the first electrode 40 can be formed of aluminum. Thus, in the BAW resonator 1, the first electrode 40 can be formed using a generally used conductive material, and the first electrode 40 can be assuredly formed using a material having a low resistivity so that the first electrode 40 can be used as a transmission line.

In the BAW resonator 1, the piezoelectric layer 50 can include MgZnO as a piezoelectric material. In general, the K value and the Q value of the piezoelectric layer, which formed by doping the piezoelectric material with another element, are in a tradeoff relationship. If a piezoelectric element is used in, for example, a high-frequency filter which extract only signals having frequencies in a high frequency region, such as a 5G band or the like and removes signals in other frequency bands, the Q value tends to decrease, when the K value required for the high frequency region is achieved. Sine the piezoelectric layer 50 includes MgZnO as the piezoelectric material, there is no tradeoff between the K value and Q value of MgZnO with respect to the concentration of Mg, and both the desired K value and the desired Q value can be achieved even in the high frequency region. Since the BAW resonator 1 includes the piezoelectric layer 50 in which MgZnO is included as the piezoelectric material, the BAW resonator 1 can stably deliver piezoelectric performance in a high frequency region of a high-frequency filter or the like.

Since the BAW resonator 1A can exhibit an effect of confining energy to reduce noise, and can provide excellent piezoelectric performance in a high frequency region, while reducing wire resistance, the BAW resonator 1A can be effectively used as a high-frequency filter, such as a BAW filter or the like.

In addition, the BAW resonator 1A can reduce noise, and can provide excellent piezoelectric performance. Thus, the BAW resonator 1A can be used in electric devices of various applications, as an electronic part using the positive piezoelectric effect or the inverse piezoelectric effect in the electronic device, in addition to the BAW filter.

Although the embodiments have been described above, the above embodiments are presented as examples, and the present invention is not limited to the above embodiments. The above embodiments can be carried out in various other forms, and various combinations, omissions, substitutions, changes, and the like can be made without departing from the gist of the invention. These embodiments and modifications of the embodiments are included within the scope or the gist of the present invention, and also included in the invention described in the scope of claims and the scope of equivalents of the claims.

Examples

The embodiments will be more specifically described through Examples and Comparative Examples hereinafter, but the embodiments are not limited according to Examples and Comparative Examples.

<Production of BAW resonator and BAW filter>

[Example 1]

(Production of acoustic mirror layer)

An acoustic mirror layer composed of high acoustic impedance layers and low acoustic impedance layers was formed.

1. Production of each high acoustic impedance layer

On a Si substrate, a tungsten (W) film was formed as a high acoustic impedance layer in an Ar atmosphere by DC magnetron sputtering using a tungsten sputtering target. The acoustic impedance of the high acoustic impedance layer was $1.0 \times 10^8$ kg/ (m$^2$·s), and the thickness of the high acoustic impedance layer was 216 nm.

2. Production of each low acoustic impedance layer

On the high acoustic impedance layer, a $SiO_2$ film was formed as a low acoustic impedance layer in an $Ar/O_2$ gas mixture atmosphere by RF magnetron sputtering using a silicon sputtering target. The acoustic impedance of the low acoustic impedance layer was $1.3 \times 10^7$ kg/(m$^2$·s), and the thickness of the low acoustic impedance layer was 242 nm.

(Production of intermediate layer)

On the low acoustic impedance layer, a ZnO film was formed as an intermediate layer in an Ar gas atmosphere by RF magnetron sputtering using a ZnO sputtering target. The acoustic impedance of the intermediate layer was $3.6 \times 10^7$ kg/(m$^2$·s), and the thickness of the intermediate layer was 15 nm.

(Production of first electrode)

On the intermediate layer, an Al film was formed as a first electrode in an Ar atmosphere by DC magnetron sputtering using an aluminum sputtering target. The acoustic impedance of the first electrode was $1.7 \times 10^7$ kg/(m$^2$·s), and the thickness of the first electrode was 160 nm.

-Measurement of surface resistivity-

The surface resistivity of the first electrode was calculated by dividing the resistivity of the first electrode by the thickness of the first electrode.

(Production of piezoelectric layer)

On the first electrode, a thin film of MgZnO having a hexagonal wurtzite structure in which a mass ratio of ZnO and MgO was adjusted to 88 wt%:12 wt% was formed as a piezoelectric layer in an $Ar/O_2$ mixed gas atmosphere by RF sputtering using a sputtering target in which a mass ratio of ZnO to MgO was adjusted to 88 wt%:12 wt%. The thickness of the thin film of MgZnO was 290 nm.

(Production of second electrode)

On the piezoelectric layer, a molybdenum film (Mo film) was formed as a second electrode in an Ar gas atmosphere by DC magnetron sputtering using a molybdenum sputtering target. The thickness of the Mo film was 89 nm.

Thus, a BAW resonator, in which the acoustic mirror layer, the intermediate layer, the first electrode, the piezoelectric layer, and the second electrode were stacked in this order on the base, was produced.

A plurality of the produced BAW resonators were coupled to thereby produce a BAW filter.

[Examples 2 to 5, and Comparative Examples 1 and 2]

A BAW filter, in which a plurality of BAW resonators were coupled, was produced in the same manner as in Example 1, except that the thickness of the intermediate layer and the thickness of the first electrode were changed to the thicknesses presented in Table 3.

[Comparative Example 3]

A BAW filter, in which a plurality of BAW resonators were coupled, was produced in the same manner as in Example 1, except that the intermediate layer was not provided, and the thickness of the first electrode was changed to the thickness presented in Table 3.

Types, acoustic impedances, and thicknesses of each high acoustic impedance layer, each low acoustic impedance layer, the intermediate layer, and the first electrode constituting the BAW resonator of each of Examples and Comparative Examples, and a ratio (film thickness ratio) of the intermediate layer to the thickness of the first electrode in each of Examples and Comparative Examples are presented in Table 3.

<Evaluation of BAW resonator and BAW filter>

The attenuation value and bandwidth of the BAW filter including the BAW resonators of each of Examples and Comparative Examples, and the wire resistance of the BAW resonator of each of Examples and Comparative Examples were measured.

[Attenuation value]

The attenuation value of the BAW filter in which a plurality of the BAW resonators were coupled was determined as a value of attenuation in a passband of the transmission signal obtained by the two-port measurement of a network analyzer. The measurement results are presented in Table 3.

[Bandwidth]

The bandwidth of the BAW filter in which a plurality of the BAW resonators were coupled was a width of the frequency band in which the attenuation value was -3 dB or greater in the passband of the transmission signal S21 obtained by the two-port measurement of the network analyzer. The measurement results are presented in Table 3.

[Wire resistance]

The wire resistance of the BAW resonator was evaluated by a value of the real part of the impedance with respect to the reflection signal S11 in a low frequency region of 1 GHz or lower obtained by a one-port measurement of the network analyzer. When the wire resistance was a value of 3 $\Omega$ or lower, the result was evaluated as "A." When the wire resistance was a value greater than 3 $\Omega$, the result was evaluated as "B." The measurement results are presented in Table 3.

[Table 3]

| | | | Ex. 1 | Ex. 2 | Ex. 3 | Ex. 4 | Ex. 5 | Comp. Ex. 1 | Comp. Ex. 2 | Comp. Ex. 3 |
|---|---|---|---|---|---|---|---|---|---|---|
| Acoustic mirror layer | High acoustic impedance layer | Type | W | W | W | W | W | W | W | W |
| | | Acoustic impedance [kg/(m²·s)] | $1.0 \times 10^8$ | $1.0 \times 10^8$ | $1.0 \times 10^8$ | $1.0 \times 10^8$ | $1.0 \times 10^8$ | $1.0 \times 10^8$ | $1.0 \times 10^8$ | $1.0 \times 10^8$ |
| | | Thickness [nm] | 216 | 216 | 216 | 216 | 216 | 216 | 216 | 216 |
| | Low acoustic impedance layer | Type | $SiO_2$ | $SiO_2$ | $SiO_2$ | $SiO_2$ | $SiO_2$ | $SiO_2$ | $SiO_2$ | $SiO_2$ |
| | | Acoustic impedance [kg/(m²·s)] | $1.3 \times 10^7$ | $1.3 \times 10^7$ | $1.3 \times 10^7$ | $1.3 \times 10^7$ | $1.3 \times 10^7$ | $1.3 \times 10^7$ | $1.3 \times 10^7$ | $1.3 \times 10^7$ |
| | | Thickness [nm] | 242 | 242 | 242 | 242 | 242 | 242 | 242 | 242 |
| Intermediate layer | | Type | ZnO | ZnO | ZnO | ZnO | ZnO | ZnO | ZnO | - |
| | | Acoustic impedance [kg/(m²·s)] | $3.6 \times 10^7$ | $3.6 \times 10^7$ | $3.6 \times 10^7$ | $3.6 \times 10^7$ | $3.6 \times 10^7$ | $3.6 \times 10^7$ | $3.6 \times 10^7$ | $3.6 \times 10^7$ |
| | | Thickness [nm] | 15 | 20 | 25 | 30 | 35 | 10 | 40 | - |
| First electrode | | Type | Al | Al | Al | Al | Al | Al | Al | Al |
| | | Acoustic impedance [kg/(m²·s)] | $1.7 \times 10^7$ | $1.7 \times 10^7$ | $1.7 \times 10^7$ | $1.7 \times 10^7$ | $1.7 \times 10^7$ | $1.7 \times 10^7$ | $1.7 \times 10^7$ | $1.7 \times 10^7$ |
| | | Thickness [nm] | 160 | 150 | 140 | 130 | 120 | 170 | 110 | 191 |
| | | Surface resistivity [Ω/sq] | 0.17 | 0.18 | 0.19 | 0.2 | 0.22 | 0.16 | 0.24 | 0.14 |
| Film thickness ratio (first electrode/intermediate layer) | | | 10.7 | 7.5 | 5.6 | 4.3 | 3.4 | 17 | 2.8 | - |
| BAW filter | Attenuation value [dB] | | -2.11 | -2.1 | -2.09 | -2.07 | -2.05 | -2.34 | -2.03 | -3.01 |
| | Bandwidth [MHz] | | 54 | 54 | 54 | 56 | 57 | 41 | 59 | 0 |
| BAW resonator | Wire resistance | | A | A | A | A | A | A | B | A |

With reference to Table 3, in each of Examples, the BAW filter had a small attenuation value and a wide bandwidth, and the BAW resonator had low wire resistance. In Comparative Example 1, the BAW resonator had a large attenuation value and a narrow bandwidth. In Comparative Example 2, the BAW resonator had high wire resistance. In Comparative Example 3, the BAW resonator had a large attenuation value, and a bandwidth of the BAW resonator was almost none.

Accordingly, it was confirmed that, since the BAW resonator of each of Examples included the intermediate layer formed of the insulator between the acoustic mirror layer and the first electrode, the intermediate layer had the higher acoustic impedance than the acoustic impedance of each low acoustic impedance layer, and the first electrode had the lower acoustic impedance than the acoustic impedance of each high acoustic impedance layer, the effect of confining the energy could be exhibited while reducing the wire resistance. Thus, the BAW resonator of each of Examples could be effectively used as a high-frequency filter, such as a BAW filter or the like.

For example, embodiments of the present invention are as follows.

<1> A BAW resonator including:

a support base;
an acoustic mirror layer including one pair of a high acoustic impedance layer and a low acoustic impedance layer, or two or more pairs of high acoustic impedance layers and low acoustic impedance layers, in which the high acoustic impedance layers and the low acoustic impedance layers are alternately stacked;
a first electrode;
a piezoelectric layer having a wurtzite crystal structure; and
a second electrode,
the support base, the acoustic mirror layer, the first electrode, the piezoelectric layer, and the second electrode being stacked in the order as mentioned,

wherein an intermediate layer formed of an insulator is provided between the acoustic mirror layer and the first electrode,
the intermediate layer has an acoustic impedance that is higher than an acoustic impedance of each low acoustic impedance layer, and
the first electrode has an acoustic impedance that is lower than an acoustic impedance of each high acoustic impedance layer.

<2> The BAW resonator according to <1>,
wherein the intermediate layer has the acoustic impedance that is at a level between the acoustic impedance of each high acoustic impedance layer and the acoustic impedance of the first electrode.
<3> The BAW resonator according to <1> or <2>,
wherein the acoustic impedance of the intermediate layer is in a range of $3.0 \times 10^7$ kg/ $(m^2 \cdot s)$ to $6.0 \times 10^7$ kg/ $(m^2 \cdot s)$.
<4> The BAW resonator according to any one of <1> to <3>,

wherein the acoustic impedance of the first electrode is lower than $3.0 \times 10^7$ kg/$(m^2 \cdot s)$, and
a resistivity of the first electrode is $3.0 \times 10^{-7}$ $\Omega$m or lower.

<5> The BAW resonator according to any one of <1> to <4>,
wherein a ratio of a thickness of the first electrode to a thickness of the intermediate layer is 3 to 11.
<6> The BAW resonator according to any one of <1> to <5>,
wherein a surface resistivity of the first electrode is lower than 0.24 $\Omega$/sq, where the surface resistivity is determined by dividing a resistivity of the first electrode by a thickness of the first electrode.
<7> The BAW resonator according to any one of <1> to <6>,
wherein the intermediate layer is formed of a same material as a material of the piezoelectric layer.
<8> The BAW resonator according to <7>,
wherein the intermediate layer includes zinc oxide as a main component.
<9> The BAW resonator according to any one of <1> to <8>,
wherein the first electrode is aluminum.
<10> An electronic device including the BAW resonator according to any one of <1> to <9>.

The present application claims priority based on Japanese Patent Application No. 2023-55029 filed with Japan Patent Office on March 30, 2023, the entire contents of which are incorporated herein by reference.

DESCRIPTION OF REFERENCE NUMERALS

1:                         BAW resonator

10:                      support base

20:                      acoustic mirror layer

21:                      high acoustic impedance layer

22:                      low acoustic impedance layer

| 30: | intermediate layer |
| 40: | first electrode |
| 50: | piezoelectric layer |
| 60: | second electrode |
| 101, 201, 301, 401, 501: | main surface (upper surface) |
| S: | space |

## Claims

1. A BAW resonator comprising:

   a support base;
   an acoustic mirror layer including

   one pair of a high acoustic impedance layer and a low acoustic impedance layer, or
   two or more pairs of high acoustic impedance layers and low acoustic impedance layers, in which the high acoustic impedance layers and the low acoustic impedance layers are alternately stacked;

   a first electrode;
   a piezoelectric layer having a wurtzite crystal structure; and
   a second electrode,
   the support base, the acoustic mirror layer, the first electrode, the piezoelectric layer, and the second electrode being stacked in the order as mentioned,
   wherein an intermediate layer formed of an insulator is provided between the acoustic mirror layer and the first electrode,
   the intermediate layer has an acoustic impedance that is higher than an acoustic impedance of each low acoustic impedance layer, and
   the first electrode has an acoustic impedance that is lower than an acoustic impedance of each high acoustic impedance layer.

2. The BAW resonator according to claim 1,
   wherein the intermediate layer has the acoustic impedance that is at a level between the acoustic impedance of each high acoustic impedance layer and the acoustic impedance of the first electrode.

3. The BAW resonator according to claim 1,
   wherein the acoustic impedance of the intermediate layer is in a range of $3.0 \times 10^7$ kg/ (m$^2$·s) to $6.0 \times 10^7$ kg/ (m$^2$·s).

4. The BAW resonator according to claim 1,

   wherein the acoustic impedance of the first electrode is lower than $3.0 \times 10^7$ kg/(m$^2$·s), and
   a resistivity of the first electrode is $3.0 \times 10^{-7}$ Ωm or lower.

5. The BAW resonator according to claim 1,
   wherein a ratio of a thickness of the first electrode to a thickness of the intermediate layer is 3 to 11.

6. The BAW resonator according to claim 1,
   wherein a surface resistivity of the first electrode is lower than 0.24 Q/sq, where the surface resistivity is determined by dividing a resistivity of the first electrode by a thickness of the first electrode.

7. The BAW resonator according to claim 1,
   wherein the intermediate layer is formed of a same material as a material of the piezoelectric layer.

8. The BAW resonator according to claim 7,

wherein the intermediate layer includes zinc oxide as a main component.

9. The BAW resonator according to claim 1,
   wherein the first electrode is aluminum.

10. An electronic device comprising:
    the BAW resonator according to claim 1.

# FIG.1

## INTERNATIONAL SEARCH REPORT

| International application No. |
| --- |
| **PCT/JP2024/010236** |

| A. | CLASSIFICATION OF SUBJECT MATTER |
| --- | --- |

***H03H 9/17***(2006.01)i; ***H10N 30/87***(2023.01)i; ***H10N 30/853***(2023.01)i
FI:   H03H9/17 F; H10N30/87; H10N30/853

According to International Patent Classification (IPC) or to both national classification and IPC

| B. | FIELDS SEARCHED |
| --- | --- |

Minimum documentation searched (classification system followed by classification symbols)

H03H9/17; H10N30/87; H10N30/853

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2021/193167 A1 (NITTO DENKO CORPORATION) 30 September 2021 (2021-09-30) entire text, all drawings | 1-10 |
| A | JP 2005-260964 A (INFINEON TECHNOLOGIES AG) 22 September 2005 (2005-09-22) entire text, all drawings | 1-10 |
| A | JP 2018-129839 A (TEKNOLOGIAN TUTKIMUSKESKUS VTT OY) 16 August 2018 (2018-08-16) entire text, all drawings | 1-10 |

☐ Further documents are listed in the continuation of Box C.      ☑ See patent family annex.

| | |
| --- | --- |
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **15 May 2024** | **28 May 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

**INTERNATIONAL SEARCH REPORT**
Information on patent family members

International application No.

**PCT/JP2024/010236**

| Patent document cited in search report | | | Publication date (day/month/year) | Patent family member(s) | | | Publication date (day/month/year) |
|---|---|---|---|---|---|---|---|
| WO | 2021/193167 | A1 | 30 September 2021 | US | 2023/0103499 | A1 | |
| | | | | entire text, all drawings | | | |
| | | | | EP | 4131438 | A1 | |
| | | | | CN | 115280673 | A | |
| JP | 2005-260964 | A | 22 September 2005 | US | 2005/0200433 | A1 | |
| | | | | entire text, all drawings | | | |
| | | | | EP | 1575165 | A1 | |
| | | | | CN | 1667947 | A | |
| JP | 2018-129839 | A | 16 August 2018 | US | 2014/0312994 | A1 | |
| | | | | entire text, all drawings | | | |
| | | | | WO | 2013/068652 | A1 | |
| | | | | KR | 10-2014-0101773 | A | |
| | | | | CN | 104205632 | A | |
| | | | | JP | 2015-502065 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11018651 B
- JP 2023055029 A